# EUROPÄISCHE PATENTSCHRIFT

(11) **EP 0 685 003 B1**
(45) Veröffentlichungstag und Bekanntmachung des Hinweises auf die Patenterteilung: **16.10.1996**
(21) Anmeldenummer: 94904133.9
(22) Anmeldetag: 13.01.1994
(51) Int. Cl.: C23C 14/30, H01J 37/32, H05H 1/24, H05H 1/42

(54) **VERFAHREN ZUR STABILISIERUNG DER PLASMAERZEUGUNG MITTELS ELEKTRONENSTRAHLVERDAMPFER**
METHOD OF STABILIZING PLASMA GENERATION BY AN ELECTRON-BEAM EVAPORATOR
PROCEDE PERMETTANT DE STABILISER LA PRODUCTION DE PLASMA AU MOYEN D'UN EVAPORATEUR A FAISCEAU ELECTRONIQUE

(30) Priorität: 16.02.1993 DE 4304613
(43) Veröffentlichungstag der Anmeldung: 06.12.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: KIRCHHOFF, Volker, D-01324 Dresden (DE); GOEDICKE, Klaus, D-01307 Dresden (DE); METZNER, Christoph, D-01324 Dresden (DE); SCHEFFEL, Bert, D-01324 Dresden (DE)
(86) Internationale Anmeldenummer: DE9400030
(87) Internationale Veröffentlichungsnummer: WO9419507

(56) Entgegenhaltungen:
- DE-A- 3 627 151
- DE-A- 4 105 014
- US-A- 3 562 141
- US-A- 4 511 594

## Beschreibung

Die Erfindung betrifft ein Verfahren zur Stabilisierung der Plasmaerzeugung bei der physikalischen Dampfabscheidung mittels Elektronenstrahlverdampfung unter Verwendung von Hochleistungs-Elektronenkanonen vom Axialtyp, wobei das Plasma direkt durch den einfallenden Elektronenstrahl, der auch zur Verdampfung benutzt wird, erzeugt wird.
Das Verfahren findet besonders bei der reaktiven Bedampfung und beim Aufdampfen von Schichten mit hohen Anforderungen an die Schichtstruktur Anwendung.
Derartige Prozesse dienen vorzugsweise zur Oberflächenveredelung von Halbzeugen und Fertigteilen, insbesondere in der Metallurgie, im Maschinenbau, der Optik und der Verpackungs- und Glasindustrie.

Die Verwendung von Elektronenkanonen hoher Leistung hat die Möglichkeit eröffnet, große Substratflächen bei niedrigen Kosten zu beschichten. Ein Nachteil dieses Verfahrens ist bei der bisherig bekannten Betriebsweise derartiger Elektronenkanonen die geringe Plasmaanregung des Dampfes. Sie ist um ein vielfaches geringer als beispielsweise bei einem Sputterprozeß. Dies ist auch ein Grund dafür, daß trotz der erzielbar hohen Verdampfungsraten die Schichteigenschaften den Anforderungen meist nicht genügen. Ein weiterer Nachteil der geringen Plasmaausbeute ist die damit verbundene geringe Reaktivität des Dampfes, so daß reaktive Beschichtungen nur mit Hilfe einer zusätzlichen Plasmaanregung erfolgreich durchgeführt werden können. Für diese Art der Plasmaanregung sind verschiedene Einrichtungen und Verfahren üblich.

Es ist bekannt, mit Hilfe einer Hohlkathodenentladung diese erforderliche Plasmaanregung zu erreichen (US 3.562.141).

Es ist auch bekannt, spezielle Glimmentladungen, die mittels einer ringförmigen Zusatzanode enstehen, zur zusätzlichen Anregung des Dampfes zu nutzen (Bunshah und Raghuram "Activated Reactive Evaporation Process for High Rate Deposition of Compounds", J. Vac. Sci. Technol., Band 9, Nr. 6, November-Dezember 1972, Seiten 1385 bis 1388).

Weiterhin ist bekannt, bei der Elektronenstrahlverdampfung einen zusätzlichen Innenraum zu realisieren, in dem eine Glimmentladung gezündet wird (DE 36 27 151 A1).

Diese bekannten Verfahren mit ihren erforderlichen Zusatzeinrichtungen haben den Nachteil, daß die benötigten Elektroden, die sich verfahrensbedingt unmittelbar im Verdampfungsraum bzw. im Dampfstrom befinden, mit einem speziellen Bedampfungsschutz versehen werden müssen. Besonders bei der Hochratebedampfung sind die bekannten Schutzeinrichtungen in kurzer Zeit durch Bedampfung unbrauchbar, und es kommt zu Störungen bzw. Instabilitäten bei der Plasmaanregung. Bei der Verdampfung von isolierenden Schichten, wie z.B. Siliziumoxid oder Aluminiumoxid, und der reaktiven Schichtbildung, wie z.B. beim Verdampfen von Titan in Sauerstoffatmosphäre, werden die Elektroden innerhalb weniger Minuten elektrisch isolierend und damit unwirksam.

Es ist weiterhin bekannt, daß bei hohen Verdampferleistungen, wie sie bei Hochrateelektronenstrahlverdampfung erreichbar sind, Dampfdichten über dem Verdampfungsgut auftreten, die das Durchdringen dieser Dampfwolken mit dem Elektronenstrahl nicht mehr ermöglichen (Alecseev, A. M.; Proc. 4th Int. Symp. on Plasma Chemestry. Zurich (1979) vol 2,742). Der Elektronenstrahl wird dabei in der Dampfwolke absorbiert, und es kommt zur Plasmaanregung. Nachteilig ist, daß infolge der durch diese Plasmaanregung bedingt um ein vielfaches sinkenden Energie, die dabei zum Verdampfungsgut gelangt, die Verdampfungsrate gegen Null geht. Damit wird auch die Dampfdichte sehr klein, und der Elektronenstrahl kann das Verdampfungsgut erneut mit seiner vollen Leistung erreichen. Dadurch wird der beschriebene Prozeß aber erneut gestartet, und es kommt zu unregelmäßigen Schwingungen mit einer Frequenz im Bereich von kleiner als 1 Hz bis zu einigen Herz. Damit schwankt auch die Verdampfungsrate in einem großen Bereich, so daß eine kontinuierliche Beschichtung nicht möglich ist. Der Prozeß ist hochgradig instabil.
Um bei den hohen Raten der Elektronenstrahlverdampfung die Plasmaanregung und damit verbundenen Instabilitäten zu umgehen, könnten die Elektronenkanonen mit hohen Beschleunigungsspannungen betrieben werden, so daß physikalisch bedingt eine geringe Anregungswahrscheinlichkeit und damit ein gutes Durchdringungsvermögen für derart dichte Dampfwolken gegeben ist. In diesem Fall sind für eine plasmagestützte Bedampfung jedoch separate, oben beschriebene Plasmaerzeuger, allerdings mit den bereits beschriebenen Nachteilen, erforderlich.

Der Erfindung liegt die Aufgabe zugrunde, ein Verfahren zu schaffen, das einen stabilen Betrieb der Elektronenstrahlverdampfereinrichtung bei hoher Verdampfungsrate erlaubt und gleichzeitig eine stabile Plasmaanregung der Dampfwolke und deren gezielte Einstellung unter Nutzung des Elektronenstrahls, ohne den Einsatz zusätzlicher Elektroden im Verdampfungsraum, ermöglicht. Es sollen damit Schichten mit spezieller Schichtstruktur hergestellt werden und eine reaktive Beschichtung möglich sein.

Erfindungsgemäß wird die Aufgabe nach den Merkmalen des Anspruches 1 gelöst. Weitere Ausgestaltungen zeigen die Unteransprüche.

Ein besonderer Vorteil dieses erfindungsgemäßen Verfahrens besteht darin, daß die Erzeugung des Plasmas keine zusätzliche Einrichtung benötigt, sondern mittels der für die Verdampfung eingesetzten Elektronenkanone parallel erfolgt. Außerdem erfolgt die Plasmaanregung verfahrensbedingt in enger Kopplung mit der Dampferzeugung, also auch bei Ablenkung des Elektronenstrahls und damit immer am Ort der höchsten Dampfdichte. Ein weiterer Vorteil ergibt sich daraus, daß keine zusätzlichen Elektroden benötigt werden, und daß man auch annähernd die gleiche Zuverlässigkeit der Plasmaanregung wie für den Verdampfungsprozeß selbst erreicht.
Eine vorteilhafte Ausgestaltung des Verfahrens bei großen Verdampferanordnungen besteht darin, den Verdampfertiegel in mehrere Zonen einzuteilen und die Plasmaintensität in jeder Zone einzeln zu bestimmen. Mit Hilfe dieser Einzelintensitäten kann dann jede Verdampfungszone in bezug auf die Plasmaanregung getrennt geregelt werden. Damit ist es möglich, über große Verdampferflächen die Eigenschaften der abgeschiedenen Schicht konstant zu halten.

Eine andere Möglichkeit besteht beim Einsatz von zwei oder mehreren Elektronenkanonen. In diesem Fall ist es möglich, eine Elekronenkanone mit hoher Beschleunigungsspannung vorzugsweise für die Verdampfung einzusetzen, und je nach Anzahl der Elektronenkanonen die übrigen Elektronenkanonen mit anderen Betriebsparametern vorzugsweise zur Plasmaanregung zu nutzen. Durch dieses Verfahren ergibt sich die Möglichkeit einer weitestgehend getrennten Einstellung von Verdampferleistung und Plasmaanregung. Da diese Elektronenkanone keine zusätzlichen Elektroden im Verdampfungsraum benötigt, ist die Zuverlässigkeit gegenüber den bekannten Lösungen um ein vielfaches höher. Die Regelung der Betriebsparameter erfolgt dabei für mindestens eine der Elektronenkanonen.

An einem Ausführungsbeispiel wird die Erfindung näher erläutert. In der zugehörigen Zeichnung ist eine Verdampfungseinrichtung im Prinzip dargestellt.

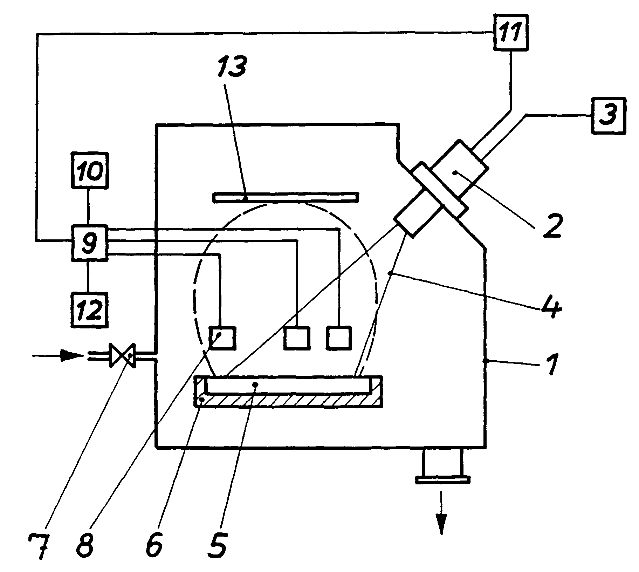

An einer Bedampfungskammer 1 ist eine Elektronenkanone 2 mit einer Nennleistung von 300 kW vom Axialtyp mit zugehörigem Strahlführungs- und Fokussierungssytem, einer Hochspannungsversorgung 3 sowie getrennter Vakuumerzeugung mit Druckstufen (nicht gezeichnet) angeflanscht. Die Elektronenkanone 2 ist mit einer sogenannten Varioanode ausgerüstet, um damit eine schnelle Änderung der Beschleunigungsspannug des Elektronenstrahls bei konstanter Strahlerleistung zu ermöglichen. Der mit der Elektronenkanone 2 erzeugte Elektronenstrahl 4 trifft bei entsprechender Programmierung des Strahlführungs- und Fokussierungssystems auf die Oberfläche des Verdampfungsgutes 5 im Verdampfertiegel 6 und erzeugt dabei einen hohen Dampfdruck oberhalb des Verdampfungsgutes 5 im Bereich von 3 Pa. Als Verdampfungsgut 5 wurde Aluminiumoxid eingesetzt. Über ein Einlaßventil 7 wird als Reaktivgas zusätzlich Sauerstoff eingelassen. Die Oberfläche des Verdampfungsgutes 5 ist in mehrere Zonen unterteilt, und jeder Zone ist ein optischer Sensor 8 zur Bestimmung der Intensität der optischen Emission bei einer Wellenlänge von 396 nm zugeordnet. (In der Zeichnung an anderer Stelle dargestellt.) Die Sensoren 8 sind mit einer Signalverarbeitungseinheit 9 verbunden, die die jeweiligen Intensitätssignale mit einem Sollwert der Sollwertvorgabeeinheit 10 vergleicht. In Abhängigkeit von diesem Vergleich wird ein Signal an die Stromversorgungseinheit 11 gegeben und damit die Beschleunigungsspannung der Elektronenkanone 2 beeinflußt.

Erhöht sich die Intensität der Plasmaemission und übersteigt dabei den vorgegebenen Sollwert innerhalb einer Zone, so wird die zugehörige Beschleunigungsspannung der Elektronenkanone 2 bei gleichbleibender Leistung durch Veränderung der Varioanode auch erhöht. Damit veringert sich die absorbierte Energie im Dampf, und die Intensität der optischen Emission nimmt ab. Ist im Gegensatz dazu die Intensität der optischen Emission geringer als durch die Sollwertvorgabeeinheit 10 vorgegeben, wird die Beschleunigungsspannug mittels der obengenannten Regelstrecke automatisch wiederum durch Veränderung der Varioanode verändert. Damit wird die Energieabsorption im Dampf erhöht, und die Intensität der Plasmaemission erhöht sich. Zur Einstellung des Arbeitspunktes wird die Elektronenkanone 2 mit einer Leistung von 180 kW betrieben und dabei mittels des Ratemonitors 12 die Verdampfungsrate bestimmt. Das zu bedampfende Substrat 13 befindet sich wie üblich über dem Verdampfertiegel 5. Danach wird die Leistung der Elektronenkanone 2 auf 200 kW erhöht. Gleichzeitig wird der Arbeitspunkt durch Veränderung der Sollwertvorgabe bestimmt. Der Arbeitspunkt ist gefunden, wenn mittels Ratemonitor 12 bei 200 kW Elektronenstrahlleistung die gleich Rate wie bei 180 kW gemessen wird.

Bei dieser Durchführung des Verfahrens wird bei einer Regelkonstante von 100 ms ein stabiler Betrieb bei der plasmagestützten Abscheidung von Aluminiumoxid erzielt. Die durch optische Emission gemessenen Schwankungen der Plasmaintensität liegen unterhalb von 10%. Die Gesamtintensität ließ sich dabei mittels der Sollwertvorgabeeinheit 10 in weiten Grenzen einstellen.

Zur Einstellung einer Energieabsorption im Plasma von größer 10% wird wie folgt verfahren:
Bei hoher Beschleunigungsspannung, bei der die Absorption der Elektronenstrahlleistung im Dampfraum vernachlässigbar ist, wird die Aufdampfrate bestimmt. Anschließend wird die Elektronenstrahlleistung um einen festen Betrag von mindestens 10% erhöht und dabei die Beschleunigungsspannung so weit abgesenkt, daß die Aufdampfrate den gleichen Wert erreicht. Dabei wird als Voraussetzung für die Stabilität der Plasmaerzeugung bereits die Regelung der Betriebsparameter der Elektronenkanonen, im vorliegenden Beispiel der Beschleunigungsspannung, wirksam.

In diesem Beispiel erfolgt die Konstanthaltung der Energieabsorption im Verdampfungsraum durch Regelung der Beschleunigungsspannung der Elektronenkanone 2. Diese Konstanthaltung ist auf gleiche Weise auch durch die Regelung der Fokussierung oder der Leistung der Elektronenkanone bei gleichbleibender Beschleunigungsspannung möglich. Es ist aber auch diese Konstanthaltung durch Regeln der Prozeßparameter, wie Verweilzeit des Elektronenstrahls auf einem Flächenelement des Verdampfungsgutes oder des Reaktivgaseinlasses, von Vorteil.

## Patentansprüche

1. Verfahren zur Stabilisierung der Plasmaerzeugung mittels Elektronenstrahlverdampfer, insbesondere bei der Verdampfung von Metallen und Verbindungen mit hoher Verdampfungsrate, gegebenenfalls bei Einlaß eines reaktiven Gases, unter Verwendung von mindestens einer Elektronenkanone vom Axialtyp, deren Elektronenstrahl durch das Strahlführungs- und Fokussierungssystem auf dem Verdampfungsgut programmiert abgelenkt wird, **gekennzeichnet dadurch**, daß die Verdampfungsrate des Elektronenstrahlverdampfers so hoch eingestellt wird, daß ein Anteil von mindestens 10% der Elektronenstrahl leistung im Verdampfungsraum durch den Dampf absorbiert wird, daß bei dieser Absorption die optische Emission des entstehenden Plasmas gemessen wird, und daß ein Betriebsparameter mindestens einer Elektronenkanone oder ein Prozeßparameter so geregelt werden, daß die optische Emission und damit die Energieabsorption im Verdampfungsraum konstant bleibt.

2. Verfahren nach Anspruch 1, **dadurch gekennzeichnet**, daß zur Konstanthaltung der Energieabsorption die Beschleunigungsspannung mindestens einer Elektronenkanone geregelt wird.

3. Verfahren nach Anspruch 1, **dadurch gekennzeichnet**, daß zur Konstanthaltung der Energieabsorption die Fokussierung mindestens einer Elektronenkanone geregelt wird.

4. Verfahren nach Anspruch 1, **dadurch gekennzeichnet**, daß zur Konstanthaltung der Energieabsorption die elektrische Leistung mindestens einer Elektronenkanone bei konstanter Beschleunigungsspannung geregelt wird.

5. Verfahren nach Anspruch 1, **dadurch gekennzeichnet**, daß zur Konstanthaltung der Energieabsorption die Verweilzeit des Elektronenstrahls auf dem Flächenelement geregelt wird.

6. Verfahren nach Anspruch 1, **dadurch gekennzeichnet**, daß zur Konstanthaltung der Energieabsorption die Reaktivgaszufuhr geregelt wird.

7. Verfahren nach Anspruch 1 und einem der Ansprüche 2 bis 6, **dadurch gekennzeichnet**, daß die Oberfläche des Verdampfungsgutes in mehrere Zonen unterteilt wird, in jeder Zone mit einem optischen Sensor die Intensität der optischen Emission gemessen wird, und danach die Betriebsparameter oder Prozeßparameter geregelt werden.

## Claims

1. A method for stabilizing the plasma generation by means of an electron beam evaporator, especially for the high-rate evaporation of metals and compounds, if necessary, also under admission of a reactive gas, and use of at least one electron beam gun of the axial type with a beam that is deflected on the evaporant by means of the beam guidance and focusing system in a programmed mode, wherein the evaporation rate of the electron beam evaporator is adjusted to such a magnitude that a proportion of at least 10 % of the beam power is absorbed by the vapor in the evaporation space, measuring the optical emission of the generated plasma at the said absorption and controlling one performance parameter of at least one electron beam gun or one process parameter so that the optical emission and therefore the energy absorption in the evaporation space remains constant.

2. A method according to claim 1 wherein the acceleration voltage of at least one electron beam gun is controlled to keep the energy absorption constant.

3. A method according to claim 1 wherein the focusing of at least one electron beam gun is controlled to keep the energy absorption constant.

4. A method according to claim 1 wherein the electric power of at least one electron beam gun is controlled at constant acceleration voltage to keep the energy absorption constant.

5. A method according to claim 1 wherein the dwell time of the electron beam on the surface element is controlled to keep the energy absorption constant.

6. A method according to claim 1 wherein the admission of the reactive gas is controlled to keep the energy absorption constant.

7. A method according to claim 1 and one of the subclaims 2 through 6 wherein the surface of the evaporant is subdivided into several zones, measuring the intensity of the optical emission by means of an optical sensor in each of the said zones and controlling the performance or process parameters accordingly.

## Revendications

1. Procédé pour stabiliser la production de plasma à l'aide d'un vaporisateur à faisceau d'électrons notamment en utilisant des métaux et des combinaisons à débit de vaporisation élevé, le cas échéant en introduisant un gaz réactif, en utilisant au moins un canon à électrons du type axial dont le faisceau d'électrons est dévié de manière programmé sur le produit à vaporiser par le système de guidage de faisceau et de focalisation,
caractérisé en ce que :
le débit de vaporisation du vaporisateur à faisceau d'électrons est réglé à un niveau tellement élevé qu'une fraction d'au moins 10 % de la puissance du faisceau d'électrons soit absorbée par la vapeur dans l'enceinte de vaporisation et, pour cette absorption, on mesure l'émission optique du plasma produit et on règle un paramètre de fonctionnement d'au moins un canon à électrons ou un paramètre du procédé pour que l'émission optique, et ainsi l'absorption d'énergie de l'enceinte de vaporisation, restent constantes.

2. Procédé selon la revendication 1,
caractérisé en ce que
pour maintenir constante l'absorption d'énergie, on règle la tension d'accélération d'au moins un canon à électrons.

3. Procédé selon la revendication 1,
caractérisé en ce que
pour maintenir constante l'absorption d'énergie, on règle la focalisation d'au moins un canon à électrons.

4. Procédé selon la revendication 1,
caractérisé en ce que
pour maintenir constante l'absorption d'énergie, on règle la puissance électrique d'au moins un canon à électrons sous une tension d'accélération constante.

5. Procédé selon la revendication 1,
caractérisé en ce que
pour maintenir constante l'absorption d'énergie, on règle le temps de séjour du faisceau d'électrons sur l'élément de surface.

6. Procédé selon la revendication 1,
caractérisé en ce que
pour maintenir constante l'absorption d'énergie, on règle d'alimentation en gaz réactif.

7. Procédé selon la revendication 1 et l'une des revendications 2 à 6,
caractérisé en ce que
on subdivise la surface du produit de vaporisation en plusieurs zones, on mesure dans chaque zone avec un capteur optique, l'intensité de l'émission optique et on règle ainsi les paramètres de fonctionnement ou les paramètres du procédé.
